# FASCICULE DE BREVET EUROPEEN

(11) **EP 3 229 283 B1**
(45) Date de publication et mention de la délivrance du brevet: **26.09.2018**
(21) Numéro de dépôt: 17165178.9
(22) Date de dépôt: 06.04.2017
(51) Int. Cl.: H01L 51/10, B82Y 10/00, B82Y 35/00, H01L 21/768

(54) **DISPOSITIF POUR CONNECTER AU MOINS UN NANO-OBJET ET SON PROCEDE DE REALISATION**
VORRICHTUNG ZUM ANSCHLIESSEN MINDESTENS EINES NANOOBJEKTS, UND IHR HERSTELLUNGSVERFAHREN
DEVICE FOR CONNECTING AT LEAST ONE NANO-OBJECT AND METHOD FOR PRODUCING SAME

(30) Priorité: 08.04.2016 FR 1653118
(43) Date de publication de la demande: 11.10.2017
(73) Titulaire: Commissariat à l'énergie atomique et aux énergies alternatives, 75015 Paris (FR)
(72) Inventeur: REYNAUD, Patrick, 38420 MURIANETTE (FR); BAILLIN, Xavier, 38920 CROLLES (FR); ROLLAND, Emmanuel, 38560 JARRIE (FR); THUAIRE, Aurélie, 38500 VOIRON (FR)
(74) Mandataire: Brevalex

(56) Documents cités:
- WO-A1-2014/001290
- LWIN MA ET AL: "Silicon on insulator nanoscale backside interconnects for atomic and molecular scale circuits", JOURNAL OF VACUUM SCIENCE AND TECHNOLOGY: PART B, AVS / AIP, MELVILLE, NEW YORK, NY, US, vol. 28, no. 5, 2 septembre 2010 (2010-09-02), pages 978-984, XP012144265, ISSN: 1071-1023, DOI: 10.1116/1.3484248

## Description

### DOMAINE TECHNIQUE ET ART ANTÉRIEUR

La présente demande concerne un dispositif pour connecter des nano-objets à au moins un système électrique externe ainsi qu'un procédé de fabrication d'un tel dispositif.

Par « nano-objets », on entend des objets dont au moins l'une des dimensions se situe dans l'intervalle allant de 0,1 nm à 1000 nm et plus particulièrement de 1 nm à 100 nm, et dans cette catégorie des nano-objets, on inclut notamment les nanoparticules (organiques ou inorganiques), les nano-fils, les molécules ou les associations de molécules, notamment les molécules biologiques telles que les virus et les bactéries.

On cherche aujourd'hui à caractériser des nano-objets de plus en plus petits ou à réaliser des structures à l'échelle du nanomètre. Il est donc nécessaire de fabriquer un dispositif permettant de mesurer électriquement ces nano-objets et de pouvoir les relier à un système électrique externe configuré pour réaliser un test électrique des nano-objets.

Le document US 2012/0161333 A1 prévoit par exemple une connexion électrique d'un nano-objet à l'aide d'éléments de connexion traversant la face arrière d'un substrat, le nano-objet étant lui-même disposé sur des zones dopées formés dans une couche semi-conductrice superficielle disposées en face avant du substrat et espacées entre elles selon un espacement déterminé.

La réalisation de ces zones dopées pose problème.

En particulier, lorsqu'on effectue une implantation de dopants dans la couche superficielle, il se produit un endommagement de la surface de cette couche qui a pour conséquence de dégrader le contact électrique entre le nano objet et les zones dopées.

Par ailleurs, un contrôle précis de l'espacement entre les zones dopées d'accueil du nano-objet est d'autant plus difficile à obtenir que le volume de la zone dopée est important.

Ces problèmes prennent une ampleur d'autant plus importante que l'on cherche généralement à réaliser les zones dopées de taille suffisamment importante pour permettre de réaliser un contact électrique de bonne qualité.

Le document WO 2014/001290 A1 concerne également une structure d'accueil pour connecter électriquement un nano-objet sur une face de celle-ci.

Il se pose le problème de réaliser un nouveau dispositif pour connecter un nano-objet ainsi qu'un nouveau procédé de réalisation d'un tel dispositif amélioré vis-à-vis de problèmes énoncés ci-dessus.

### EXPOSÉ DE L'INVENTION

Un mode de réalisation de la présente invention prévoit un procédé de réalisation d'un dispositif pour connecter au moins un nano-objet à un système électrique externe, le procédé comprenant des étapes consistant à :
a) former dans une couche semi-conductrice d'un support des premières zones dopées sur lequel le système électrique externe est apte à être connecté, les premières zones dopées ayant une première épaisseur e₁,
b) former des deuxièmes zones dopées entre les premières zones dopées, chaque première zone dopée étant en contact avec une desdites deuxième zones dopées, les deuxièmes zones dopées ayant une deuxième épaisseur e₂ inférieure à ladite première épaisseur e₁, puis
c) disposer un nano-objet sur les deuxièmes zones dopées.
L'ordre des étapes a) et b) peut être inversé. Ainsi, on peut former les zones dopées destinées à accueillir le nano-objet et que l'on appelle deuxièmes zones dopées, puis former les zones dopées que l'on appelle premières zones dopées et sur lesquelles le système électrique externe est apte à être connecté.

Du fait qu'elles résultent typiquement d'une ou plusieurs implantations ioniques à une profondeur moindre que les première zones dopées, les deuxièmes zones dopées ont, après implantation, un endommagement en surface, inférieure à celle des premières zones dopées. Or, en diminuant cet endommagement et donc la rugosité en surface de la couche semi-conductrice, on améliore le contact électrique du nano-objet sur ledit support.

Les deuxièmes zones dopées ont typiquement une concentration de dopants limitées à la proche surface (de l'ordre de plusieurs nanomètres) ce qui facilite le contrôle de la diffusion des dopants et par conséquent une définition précise de la distance G ou espacement G entre les deuxièmes zones dopées.

Le procédé peut comprendre en outre, après formation des deuxièmes zones dopées et préalablement à l'étape c) au moins un recuit thermique.

Un tel recuit peut permettre d'activer les dopants des premières zones dopées et deuxièmes zones dopées et de modifier l'état de surface des zones dopées. On diminue ainsi en particulier la rugosité des deuxièmes zones dopées, ce qui permet de faciliter l'assemblage ultérieur du nano-objet sur ces zones.

Un recuit de diffusion des dopants permet de contrôler de façon précise la distance G. Un tel recuit permet également de reconstruire une surface endommagée par implantation.

Le recuit thermique est donc ainsi réalisé selon des conditions (durée et température) permettant de réaliser une fonction d'activation de dopants et une fonction de reconstruction de surface. Le recuit peut être effectué en deux étapes : une étape activation de dopants et une autre étape permettant une reconstruction de surface.

L'atmosphère dans laquelle le recuit est effectué peut être également adaptée de sorte à réaliser une fonctionnalisation des deuxièmes zones dopées. Par exemple des fonctions Si-H, Si-OH, Si-NH2, Si-CH3 et Si-COOH peuvent être formées.

En particulier, lorsque la couche semi-conductrice est en silicium, le recuit thermique peut être réalisé sous atmosphère d'hydrogène, ce qui peut permettre de former des liaisons Si-H.

Le support sur lequel les zones dopées sont formées peut être un substrat de type semi-conducteur sur isolant comprenant une couche isolante sur laquelle repose ladite couche semi-conductrice et une couche de support sur laquelle repose la couche isolante.

Selon un mode de réalisation, le procédé peut comprendre en outre après l'étape c), des étapes :
- d'assemblage de la couche semi-conductrice à un autre support, puis
- de retrait de la couche de support et de la couche isolante dudit substrat.

Ainsi, on peut réaliser un retournement de la couche semi-conductrice et pouvoir réaliser un dispositif dans lequel le nano-objet est encapsulé et ainsi protégé.

De manière avantageuse, les premières zones dopées peuvent être formées partiellement à l'aide d'au moins une implantation de la couche superficielle à l'aide d'un faisceau d'ions pénétrant par une première face de la couche semi-conductrice, cette première face étant mise en contact avec ledit autre support lors dudit assemblage et étant opposée à une deuxième face en contact avec la couche isolante, puis, après retrait de la couche de support du substrat: au moins une autre implantation de la couche superficielle à l'aide d'un faisceau d'ions pénétrant par la deuxième face de la couche semi-conductrice superficielle, de sorte à étendre les premières zones dopées. Cela permet d'implanter des couches semi-conductrices profondes. La profondeur d'implantation étant limitée, le fait d'implanter en face avant puis en face arrière permet de doubler l'épaisseur de la zone implantée.

Selon une possibilité de mise en oeuvre pour laquelle le support peut être doté d'une couche isolante sur laquelle repose la couche semi-conductrice et d'une couche de support sur laquelle repose la couche isolante, le procédé peut comprendre en outre une étape de formation d'éléments conducteurs traversant la couche de support et la couche isolante et venant en contact avec les premières zones dopées.

On réalise en particulier de tels éléments conducteurs lorsque les premières zones dopées ont une épaisseur égale à l'épaisseur de la couche semi-conductrice et sont donc accessibles par la face arrière du support.

Selon un autre aspect, la présente invention concerne un dispositif pour connecter au moins un nano-objet à un système électrique externe, le dispositif comprenant un support muni d'une couche semi-conductrice dans laquelle des premières zones dopées espacées entre elles sont agencées, un système électrique externe étant apte à être connecté aux premières zones dopées, chaque première zone dopée étant en contact avec une deuxième zone dopée sur laquelle une portion du nano-objet est disposée, les deuxièmes zones dopées étant espacées entre elles et ayant une épaisseur inférieure à l'épaisseur des première zones dopées.

Ainsi, selon l'invention on prévoit un dispositif avec deux types de zones dopées : des premières zones dopées adaptées pour accueillir des éléments, tels que des électrodes, d'un système électrique externe comportant des moyens de lecture, ou de test ou de commande, des deuxièmes zones dopées adaptées pour recevoir des portions d'au moins un nano-objet.

Prévoir des deuxièmes zones dopées avec une épaisseur plus faible que celle des premières zones dopées permet d'obtenir un meilleur état de surface des deuxième zones dopées et un espacement plus précis.

Les premières zones dopées peuvent être prévues avec une surface en vue de dessus supérieure à celle des deuxièmes zones dopées.

Un tel agencement permet à la fois un meilleur contact électrique des nano-objets sur les deuxièmes zones dopées tout en conservant des tailles de premières zones dopées compatibles avec un système électrique externe et un contrôle précis de l'espacement G entre les deuxièmes zones dopées.

Ainsi, les premières zones dopées ont des dimensions adaptées à celles d'éléments d'un système électrique externe, par exemple des éléments de taille micrométrique comme des pointes ou électrodes, tandis que les deuxièmes zones dopées ont des dimensions nanométriques adaptées à celles du nano-objet.

Avantageusement, l'épaisseur des premières zones dopées peut être égale à l'épaisseur de ladite couche semi-conductrice, ce qui permet dans ce cas un accès par la face inférieure de ladite couche semi-conductrice.

Le dispositif peut comporter plusieurs ensembles encore appelés « groupes » de premières et de deuxièmes zones dopées chaque groupe pouvant permettre de connecter un nano-objet de taille donnée qui peut être différente de celle de nano-objets situés sur des groupes différents de zones dopées.

Dans ce cas, d'un groupe à l'autre de zones dopées les premières et deuxièmes zones dopées peuvent avoir des tailles différentes. D'un groupe à l'autre de zones dopées l'espacement G ou la distance G entre deuxièmes zones dopées peuvent varier.

Les premières zones dopées peuvent être entourées d'une région isolante ou d'un espace vide, afin d'éviter par exemple que des signaux parasites ne viennent perturber des mesures effectuées sur le nano-objet. Cela permet d'isoler le dispositif du reste du substrat. La région isolante est située en dehors des deuxièmes zones dopées avec lesquelles les premières zones dopées sont en contact.

Le dispositif peut être doté de plusieurs nano-objets.

Selon une possibilité de mise en oeuvre, le nano-objet comporte une première portion disposée sur une desdites deuxièmes zones dopées et une deuxième portion sur une autre desdites deuxièmes zones dopées, ladite autre deuxième zone dopée comportant une autre portion d'un autre nano-objet.

Avantageusement, le dispositif peut comporter une première portion disposée sur une desdites deuxième zones dopée ayant un dopage de type N et une deuxième portion sur une autre desdites deuxièmes zones dopées, ladite autre deuxième zone dopée ayant un dopage de type P. Cela permet de mettre en oeuvre une jonction P/N d'un composant par exemple de type diode, transistor, ou cellule solaire.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un dispositif suivant un mode de réalisation de la présente invention pour connecter au moins un nano-objet formé sur un substrat avec un système électrique externe, le substrat comportant une couche semi-conductrice superficielle avec des première zones dopées dédiées à l'accueil dudit nano-objet et des deuxième zones dopées de dimensions plus importantes sur lesquelles le système électrique externe est destiné à être connecté;
- la figure 2 sert à illustrer une variante de réalisation du dispositif suivant l'invention avec des vias traversants connectés aux zones dopées et reliant ces zones avec un contact électrique de taille micronique par la face arrière du substrat ;
- la figure 3 illustre une variante de réalisation dans lequel le nano-objet est encapsulé ;
- la figure 4 illustre un exemple de réalisation particulier dans lequel les premières zones dopées ont une épaisseur correspondant à celle de la couche semi-conductrice dans laquelle elles sont formées ;
- la figure 5 illustre un exemple de réalisation dans lequel le dispositif comporte plusieurs nano-objets connectés à une même zone dopée ;
- la figure 6 illustre un exemple de réalisation avec plusieurs zones dopées et plusieurs nano-objets ;
- la figure 7 illustre un exemple de réalisation pour lequel le nano-objet est recouvert d'une couche isolante et dans lequel un contact avec les premières zones dopées est réalisé par le biais de pistes conductrices ;
- les figures 8A-8E illustrent, par le biais de vues en coupes transversales un exemple de procédé de réalisation d'un dispositif suivant l'invention ;
- les figures 9A-9B représentent des exemples de profils de dopage pour différentes températures ;
- la figure 10 illustre un exemple de réalisation dans lequel la couche semi-conductrice superficielle est recouverte par une couche isolante de protection ;
- la figure 11 illustre une étape d'assemblage de la couche semi-conductrice superficielle avec un autre support ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « avant », « arrière », « supérieure », « inférieure », etc. d'une structure s'appliquent en considérant que la structure est orientée de la façon illustrée sur les figures.

### EXPOSÉ DÉTAILLÉ DE MODES DE RÉALISATION PARTICULIERS

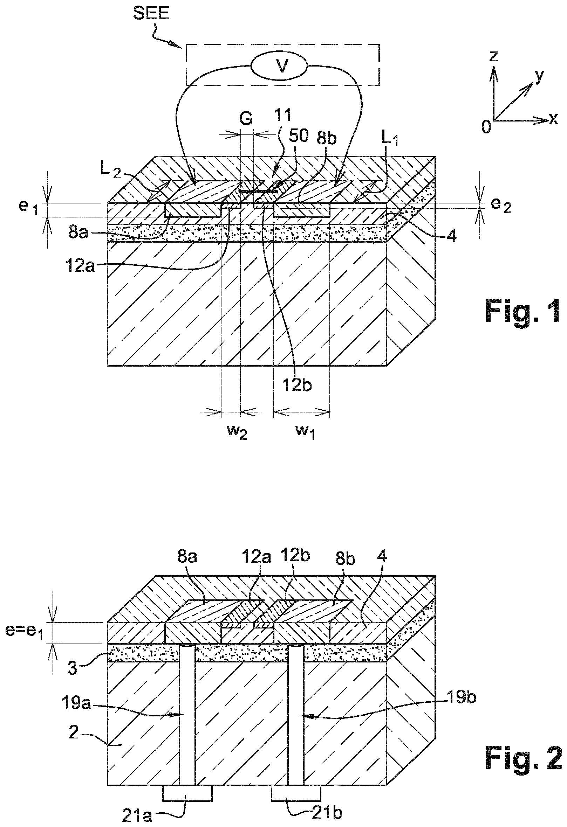

On se réfère à présent à la figure 1 donnant une vue en coupe d'un dispositif pour connecter au moins un nano-objet à un système électrique externe.

Le nano-objet 50 peut être de nature organique, par exemple de l'ADN, ou une molécule biologique, une protéine, un virus, ou sous forme de fibre(s), ou bien de nature inorganique, par exemple sous forme de nano-particules, ou d'un nano-fil semi-conducteur, ou d'un élément en matériau polymère.

Le système électrique SEE peut être doté d'un dispositif de commande apte à émettre des signaux en direction du nano-objet 50 et/ou de traitement de signaux issus du nano-objet 50 ou encore d'un dispositif de lecture de signaux électrique destinés à transiter par le nano-objet 50, ou d'un dispositif de test ou de caractérisation permettant, par exemple, de déterminer des propriétés électriques du nano-objet 50. Typiquement, le système électrique SEE se présente sous forme d'un circuit intégré.

Le nano-objet 50 est disposé sur une couche semi-conductrice superficielle 4 d'un substrat 1, cette couche superficielle étant par exemple en silicium ou en germanium ou en silicium germanium. Dans l'exemple de la figure 1, la couche semi-conductrice superficielle 4 est agencée sur une couche isolante 3 elle-même disposée sur une couche de support 2 semi-conductrice.

Dans la couche semi-conductrice superficielle 4 des premières zones dopées 8a, 8b espacées entre elles sont prévues pour accueillir des éléments du système électrique externe SEE, en particulier des électrodes, par exemple sous forme de pointes.

Les premières zones dopées 8a, 8b sont agencées de part et d'autre, et en contact, de deuxièmes zones dopées 12a, 12b sur lesquelles des extrémités ou portions du nano-objet 50 sont agencées. Les deuxièmes zones dopées 12a, 12b sont séparées entre elles d'un espacement G de l'ordre de plusieurs nanomètres, et situées de part et d'autre d'une région 11 non dopée ou faiblement dopée de la couche superficielle 4. Par « faiblement dopée » on entend un dopage de préférence inférieur à 1^{e}14 atomes/cm³.

Les deuxièmes zones dopées 12a, 12b situées entre les premières zones dopées 8a, 8b sont prévues avec une épaisseur (également appelée hauteur) e₂ plus faible que l'épaisseur ou la hauteur e₁ des premières zones dopées 8a, 8b. Les épaisseurs e₁, e₂ sont mesurées parallèlement à l'axe z d'un repère orthogonal [O ; x; y ; z] donné sur la figure 1.

Les deuxièmes zones dopées 12a, 12b sont de préférence également prévues avec une surface en vue de dessus S₂ = W₂ × L₂ plus faible que la surface en vue de dessus Si = W₁ × L₁ des premières zones dopées 8a, 8b. Les surfaces S₁ et S₂ en vue de dessus sont mesurées parallèlement au plan principal du substrat 1. Par « plan principal » du substrat 1, on entend un plan parallèle au substrat 1 et qui est parallèle au plan [O ; x ; y] du repère orthogonal [O ; x ; y ; z] donné sur la figure 1. Les longueurs Li, L₂ et les largeurs W₁, W₂ respectives des premières zones dopées 8a, 8b et des deuxièmes zones dopées 12a, 12b sont des dimensions mesurées parallèlement au plan [O ; x ; y]. Les valeurs de L₁ et W₁ sont adaptées en fonction du système électrique externe utilisé, tandis que L₂ et W₂ sont prévues en fonction du type de nano-objet assemblé.

Ainsi, les premières zones dopées 8a, 8b ont typiquement une section transversale supérieure à celles des deuxième zones dopées 12a, 12b. La section transversale est une section prise orthogonalement au plan [O ; x ; y] du repère orthogonal [O ; x ; y ; z].

Du fait de leurs dimensions plus faibles que les premières zones dopées 8a, 8b, les deuxièmes zones dopées 12a, 12b ont une région superficielle en surface de la couche semi-conductrice 4 de plus faible rugosité et/ou un endommagement en surface moins important que les premières zones dopées 8a, 8b. Les deuxièmes zones dopées 12a, 12b ont également un espacement G défini de manière plus précise que celui prévu entre les premières zones dopées 8a, 8b.

Une faible rugosité, en particulier inférieure à 1.5 Â RMS mesuré par microscope à AFM avec une surface étudiée de 1x1 µm², permet au nano-objet 50 d'avoir une bonne adhérence sur les deuxièmes zones dopées 12a, 12b. Par ailleurs, les deuxièmes zones dopées 12a, 12b, ont un espacement G défini de manière très précise, en particulier d'une précision de l'ordre de quelques nanomètres, typiquement 30 nm.

Une mise en oeuvre particulière prévoit des premières zones dopées 8a, 8b avec une épaisseur e₁ correspondant à l'épaisseur e de la couche superficielle semi-conductrice, ce qui peut permettre notamment de réaliser une prise de contact sur les premières zones dopées 8a, 8b au niveau de la face inférieure de la couche semi-conductrice superficielle 4, c'est-à-dire une face de cette couche superficielle 4 contre laquelle se trouve une portion inférieure du substrat 1, et en particulier contre laquelle la couche isolante 3 s'étend.

Une telle prise de contact est illustrée sur la figure 2 donnant une variante de réalisation du dispositif dans lequel des éléments conducteurs 19a, 19b verticaux communément appelés « vias » traversent la couche de support 2 et la couche isolante 3 pour accéder aux premières zones dopées 8a, 8b. Ces éléments conducteurs 19a, 19b, débouchent en face arrière du substrat 1 et sont dans cet exemple reliés à des plots conducteurs 21a, 21b formés en face arrière du substrat 1, c'est-à-dire au niveau d'une face du substrat 1 opposée à la face avant elle-même définie par la face supérieure de la couche superficielle 4, c'est-à-dire la face de la couche superficielle 4 opposée à ladite face inférieure. Les plots conducteurs 21a, 21b peuvent avoir une longueur correspondant à l'épaisseur de la couche de support 2 et typiquement comprise entre un micron et plusieurs centaines de microns voire plusieurs millimètres.

Les éléments conducteurs 19a, 19b verticaux sont typiquement réalisés par formation de trous traversant la couche de support 2 du substrat 1 jusqu'à dévoiler les premières zones dopées 8a, 8b, puis remplir ces trous par un matériau conducteur, par exemple un matériau métallique tel que du Cu ou du W.

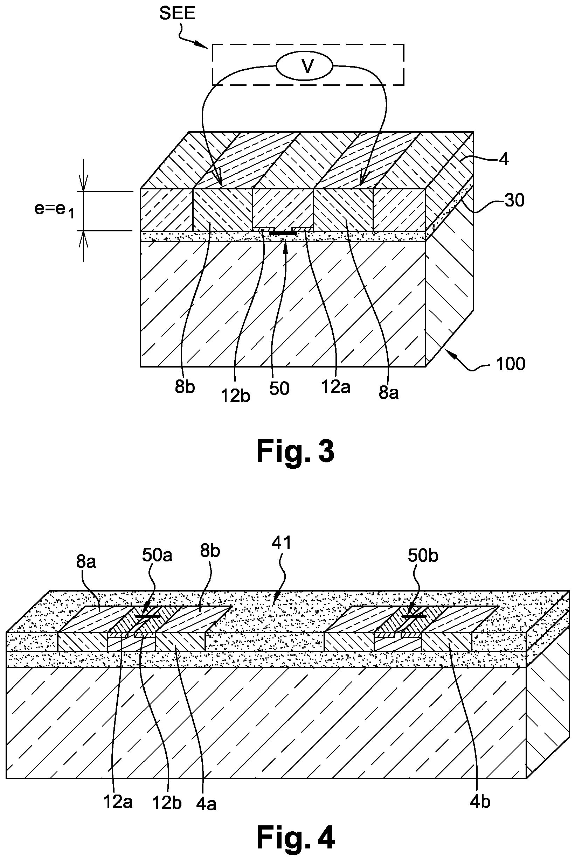

Selon une autre configuration, illustrée sur la figure 3, le nano-objet 50 et les deuxièmes zones dopées 12a, 12b sont disposées au niveau de la face inférieure de la couche semi-conductrice superficielle 4 et ainsi intercalées entre une portion de la couche semi-conductrice superficielle 4 et une portion inférieure du substrat 1. Le nano-objet 50 est ainsi totalement encapsulé et protégé. L'épaisseur e₁ des premières zones dopées 8a, 8b est égale à l'épaisseur e de la couche superficielle semi-conductrice 4 ce qui permet de connecter un système électrique externe SEE aux premières zones dopées 8a, 8b en face avant du substrat 1, sans nécessairement faire appel à une mise en oeuvre d'éléments conducteurs supplémentaires. Cela peut alors permettre de rendre la fabrication du dispositif plus simple et moins coûteuse.

Une telle configuration peut être obtenue en réalisant un dispositif tel qu'illustré sur la figure 1, puis en assemblant le substrat 1 à un autre support, par exemple à un autre substrat 100 semi-conducteur ou isolant, ou semi-conducteur, par exemple en silicium recouvert d'une couche isolante, par exemple une couche d'oxyde. Cet autre substrat 100 peut être éventuellement flexible, et par exemple en polyimide ou en Graphène.

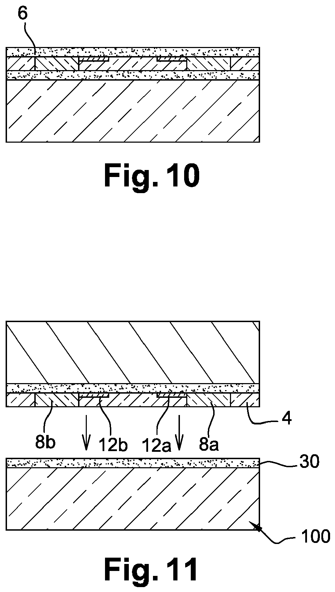

L'assemblage est alors réalisé par exemple par collage moléculaire de la couche semi-conductrice superficielle 4 sur une couche isolante 30 (figure 11) ou par collage moléculaire d'un revêtement isolant formé sur la couche semi-conductrice superficielle 4 avec une couche isolante 30 de l'autre substrat 100. Une fois cet assemblage réalisé, on peut ensuite éliminer la portion inférieure du substrat 1 d'origine, c'est à dire retirer la couche isolante 3 et la couche de support 2. L'assemblage peut être également réalisé à l'aide d'une colle, par exemple une colle à base d'Indium ou en utilisant un polymère adhésif.

La réalisation des premières zones dopées peut dans ce cas être effectuée en plusieurs étapes, et en particulier en plusieurs implantations ioniques. Des implantations réalisées par la face avant et par la face arrière peuvent permettre en particulier d'implanter des épaisseurs plus importantes que lorsqu'on effectue une implantation par une seule face. Le fait d'implanter en face avant d'effectuer un report, puis après report, d'implanter par la face arrière peut permettre de doubler l'épaisseur de la zone implantée. Cela permet également de moins endommager la surface en face avant du substrat.

Ainsi, au moins une première implantation de la couche semi-conductrice superficielle 4 est effectuée par la face avant du substrat 1 avant que l'on ne réalise l'assemblage avec un autre support. On effectue ensuite au moins une deuxième implantation de la couche semi-conductrice superficielle 4 après avoir effectué l'assemblage et retiré la couche isolante 3. Lors de la première implantation, les premières zones dopées 8a, 8b peuvent être implantées dans seulement une partie de la couche semi conductrice superficielle 4, par exemple de l'ordre de plusieurs micromètres d'épaisseur, le complément de dopage, par exemple également de l'ordre de plusieurs micromètres d'épaisseur, est ensuite effectué afin d'étendre les premières zones dopées 8a, 8b sur toute l'épaisseur de la couche semi-conductrice superficielle 4 et ce après report de cette couche semi-conductrice superficielle 4 sur l'autre support.

On peut prévoir de disposer plusieurs nano-objets sur un même substrat 1.

La figure 4 illustre un exemple de réalisation dans lequel des nano-objets 50a, 50b sont disposés respectivement sur des régions semi-conductrices 4a, 4b reposant sur un substrat et séparées entre elles par une couche isolante 41, par exemple en SiO₂.

Une telle isolation permet de limiter les interférences ou perturbations entre des signaux de test ou de commande ou de lecture respectifs des nano-objets 50a, 50b. La couche isolante 41 peut être répartie de manière à entourer totalement les régions semi-conductrices 4a, 4b.

En variante, pour réaliser une telle isolation, on remplace la couche isolante 41 par du vide, les régions semi-conductrices 4a, 4b étant alors séparées entre elles par un espace vide.

Les deuxièmes zones dopées 12a, 12b peuvent être éventuellement prévues pour accueillir chacune plusieurs nano-objets.

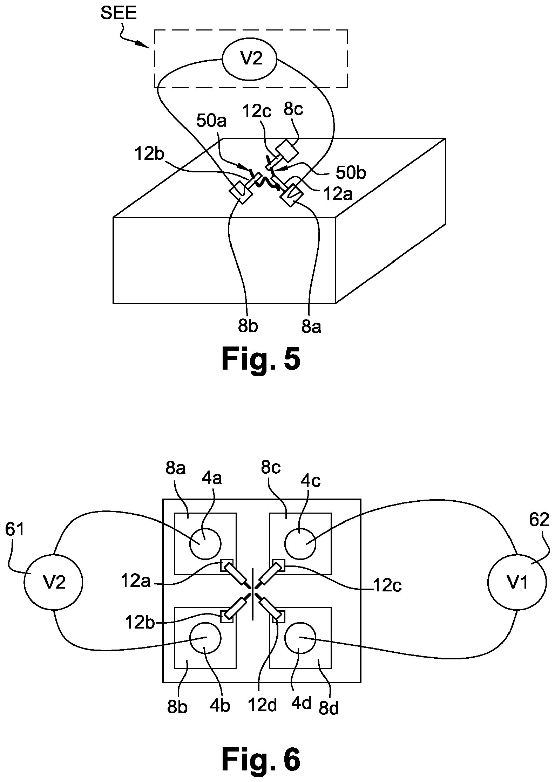

Dans l'exemple de réalisation illustré sur la figure 5, le dispositif est doté de plus de deux régions semi-conductrices, chacune comportant une première zone dopée 8a, 8b, 8c pour la prise de contact avec un système électrique externe et une deuxième zone semi-conductrice 12a, 12b, 12c pour l'accueil d'un ou plusieurs nano-objets. Le dispositif comprend ici un premier nano-objet 50a ayant une portion connectée à une zone dopée 12b et à une autre zone dopée 12a.

Un deuxième nano-objet 50b comporte quant à lui une portion connectée à cette autre zone dopée 12a et à une zone dopée 12c différente. La zone dopée 12a est ainsi commune à plusieurs nano-objets 50a, 50b. On peut déterminer des propriétés électriques du premier nano-objet 50a en réalisant une mesure électrique entre les zones dopées 8a et 8b. Si l'on souhaite déterminer des propriétés électriques du deuxième nano-objet 50b, le dispositif de mesure de tension peut être placé sur les zones dopées 8a et 8c.

Un autre exemple de configuration avec plusieurs dispositifs 61, 62 de mesure de tension est donné sur la figure 6. La couche semi-conductrice superficielle comporte cette fois quatre paires de zones dopées 8a-12a, 8b-12b, 8c-12c, 8d-12d, respectivement dans des régions semi-conductrices 4a, 4b, 4c, 4d, chaque paire comportant une zone dopée 8a (respectivement 8b, 8c, 8d) pour la prise de contact avec un système électrique externe et une zone dopée 12a, (respectivement 12b, 12c, 12d) pour recevoir au moins un nano-objet.

Un premier dispositif de mesure de tension 61 est connecté aux zones dopées 8a, 8b d'une première région semi-conductrice 4a et d'une deuxième région semi-conductrice 4b, tandis qu'un deuxième dispositif de mesure de tension 62 est quant à lui relié aux zones dopées 8c, 8d d'une troisième région semi-conductrice 4c et d'une quatrième région semi-conductrice 4d.

On peut prévoir des dopages différents entre les régions semi-conductrices. Par exemple, on prévoit deux paires de zones dopées 8a-12a, 8d-12d, dopées selon un dopage d'un premier type par exemple de type N et deux autres paires de zones dopées 8b-12b, 8c-12c selon un dopage d'un deuxième type par exemple de type P. Ce type de dispositif permet d'effectuer un test d'un même nano-objet avec plusieurs type de dopants.

Dans un exemple où les nano-objets sont sous forme par exemple de nano-fils déposés ou fabriqués entre 2 électrodes de même type de dopage (P ou N), on peut, avec ces deux paires de zones dopées, mettre en oeuvre un transistor P et un transistor N à canal sous forme de nano-fils et qui sont juxtaposés. Avec ces deux paires de zones dopées, on peut en variante, former deux jonctions P/N ou diodes P/N, le nano objet étant disposé entre une électrode de type P et une électrode de type N. Cela permet donc une gestion plus aisée des composants du circuit, et une distance entre dispositifs plus courte.

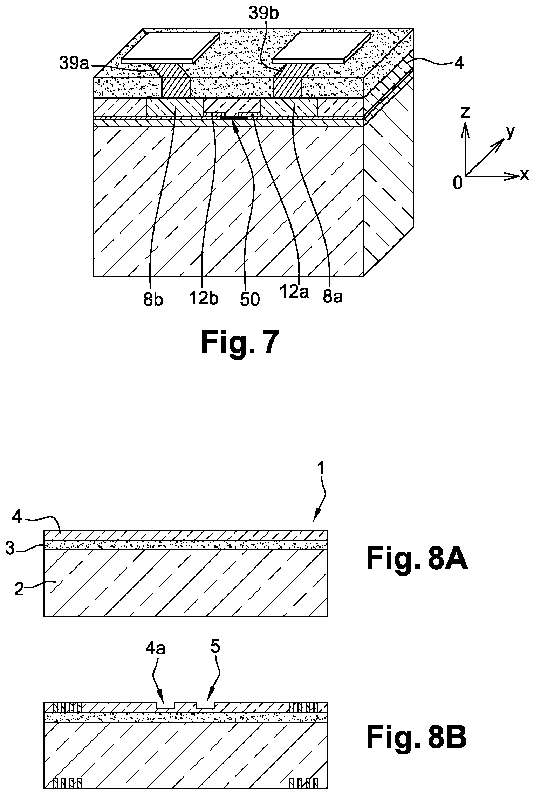

Sur la figure 7 une variante du dispositif de la figure 3 est illustrée, la couche semi-conductrice superficielle 4 étant cette fois protégée sur le dessus par une couche isolante 3. Cette couche isolante 3 peut être une couche issue d'un substrat 1 de type semi-conducteur sur isolant sur lequel se trouvait initialement la couche semi-conductrice 4 que l'on a ensuite reporté sur un autre substrat 100 avant de retirer la couche de support 2 du substrat semi-conducteur sur isolant.

Pour permettre un accès aux premières zones dopées 8a, 8b sur lesquelles un système électrique externe est destiné à être connecté et qui sont recouvertes par la couche isolante 3, des pistes conductrices 39a, 39b sont formées.

On peut prévoir des pistes conductrices 39a, 39b qui s'étendent contre des faces latérales de la structure et viennent en contact avec les premières zones dopées 8a, 8b. Par « faces latérales » on entend des faces qui réalisent un angle non-nul, en particulier orthogonal avec le plan principal du substrat.

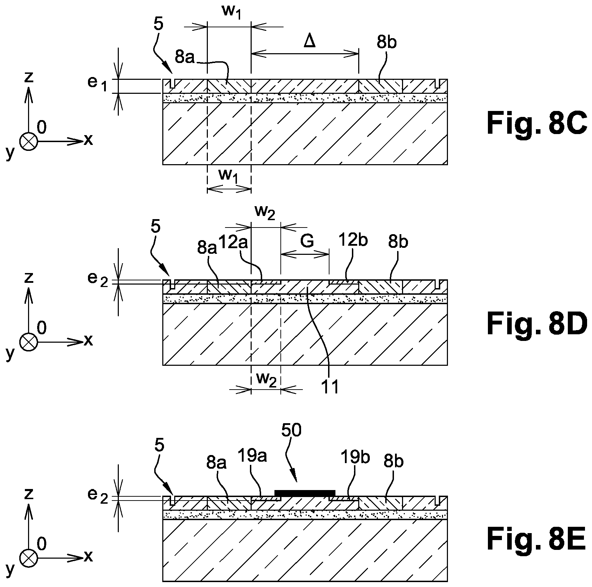

Un exemple de procédé de fabrication d'un dispositif du type de celui précédemment décrit précédemment par exemple en lien avec la figure 1, va à présent être donné en liaison avec les figures 8A-8E.

Le matériau de départ de ce procédé peut être un substrat 1 de type semi-conducteur sur isolant (figure 8A) en particulier de type SOI (pour « Silicon On Insulator ») ou GeOI ou SiGeOI, ou sSOI (« strained Silicon On Insulator ») comprenant une couche 2 de support semi-conductrice revêtue d'une couche isolante 3 dite de BOX (pour « Burried Oxide »), elle-même revêtue d'une couche superficielle 4, en matériau semi-conducteur par exemple à base de Si, ou de Ge ou de SiGe, le matériau semi-conducteur pouvant être contraint. La couche superficielle 4 peut avoir une épaisseur par exemple comprise entre 1 nm et plusieurs µm, tandis que celle de la couche SiO₂ est comprise entre 10 nm et plusieurs µm.

On réalise ensuite des motifs dans la couche superficielle 4, en particulier sous forme de tranchées 5 afin de délimiter une ou plusieurs régions semi-conductrices d'intérêts 4a de la couche superficielle 4, chaque région semi-conductrice d'intérêt étant apte à accueillir au moins un nano-objet (figure 8B).

Les tranchées 5 forment ainsi des marques de localisation situées autour des régions d'intérêts 4a et permettant de localiser ces régions 4a. La ou les régions d'intérêts 4a peuvent avoir une surface par exemple comprise entre 10 nm² et 1 mm², en particulier entre 0.01 µm x 0.01 µm et 10 µm x 10 µm.

Pour réaliser les tranchées 5 on utilise par exemple une technique de photolithographie lors de laquelle on forme un masque de résine, puis on effectue une gravure de la couche semi-conductrice 4 à travers ce masque et on retire enfin le masque de résine. De telles tranchées 5 sont détectables par un dispositif d'imagerie doté par exemple d'un microscope.

Ensuite, on forme des premières zones dopées 8a, 8b distinctes dans la couche superficielle 4. Ces zones dopées sont réalisées dans la (ou les) région(s) d'intérêt 4a, et peuvent être formées en particulier par implantation ionique à travers un masquage (non représenté).

Les premières zones dopées 8a, 8b réalisées à l'intérieur d'un périmètre délimité par les tranchées 5 ou marques de localisation sont aptes à être mises en contact électrique avec un dispositif de mesure externe, en particulier à des pointes de mesure d'un tel dispositif. Typiquement, on peut réaliser deux zones dopées P ou N par région semi-conductrice d'intérêt 4a. La distance Δ entre les deux zones dopées 8a, 8b peut être comprise par exemple entre plusieurs nanomètres et plusieurs centaines de microns. Le choix de l'espèce dopante des premières zones dopées 8a, 8b est effectué en fonction de l'application choisie.

On adapte les paramètres d'implantation (énergie, dose, courant) en fonction de l'épaisseur de la couche superficielle 4. Les premières zones dopées 8a, 8b peuvent avoir une épaisseur e₁ égale à celles de la couche superficielle 4, la couche superficielle 4 étant dans ce cas implantée sur toute son épaisseur.

A titre d'exemple, le tableau ci-dessous répertorie des exemples de conditions d'implantation avec différents dopants de type N ou P, pour différents dimensionnements des premières zones dopées 8a, 8b, d'une couche semi-conductrice superficielle 4 en silicium de 205 nm d'épaisseur d'un substrat SOI avec une couche de BOX de 400 nm et une couche de support de 725 µm.

| dopant | paramètres | Valeur min | Valeur Max | typiquement |
|---|---|---|---|---|
| Bore | Longeur L₁ | 1 µm | Plusieurs millimètres | 70-100 µm |
| | Largeur W₁ | 1 µm | Plusieurs millimètres | 70-100 µm |
| | Hauteur ou épaisseur e₁ | plusieurs nm | Plusieurs microns | 200 nm pour une e₁= 200 nm |
| | Energie | 3 kev | 500 kev | 30kev/3E15 atm/cm² |
| | Dose | 1E12 atm/cm² | 1^{E}16 at/cm² | |
| Phosphore | Longeur L₁ | 1 µm | Plusieurs millimètres | 70-100 µm |
| | Largeur W₁ | 1 µm | Plusieurs millimètres | 70-100 µm |
| | Hauteur ou épaisseur e₁ | plusieurs nm | Plusieurs microns | 200 nm |
| | Energie | 3 kev | 500 kev | 85kev/3E15 atm/cm² |
| | Dose | 1E12 atm/cm² | 1^{E}16 atm/cm² | |
| Arsenic | Longeur L₁ | 1 µm | Plusieurs millimètres | 70-100 µm |
| | Largeur W₁ | 1 µm | Plusieurs millimètres | 70-100 µm |
| | Hauteur ou épaisseur e₁ | plusieurs nm | Plusieurs microns | 200 nm |
| | Energie | 3kev | 500 kev | 150 kev/3E15 + 50 kev 2E15 atm/cm²) |
| | Dose | 1E12 atm/cm² | 1E16 atm/cm² | |

A l'issue de la ou des implantations, les premières zones dopées 8a, 8b peuvent avoir une rugosité comprise entre 2 et 3 Â RMS (pour « Roughness mean square ») mesurée par microscope à force atomique (AFM pour « Atomic Force Microscope ») avec une surface étudiée de 1x1 µm² de silicium.

Dans le cas notamment où l'on implante de l'Arsenic, au moins deux implantations successives sont de préférence réalisées afin de permettre d'uniformiser la dose d'implantation dans toute l'épaisseur de couche superficielle 4. Les valeurs données dans le tableau ci-dessus correspondent à une technique d'implantation ionique par faisceau d'ions. On peut noter que cette dose correspond dans la couche superficielle 4 à une concentration en dopants entre 1E15 atomes/cm³ et 1E20 at./cm³.

Ensuite, on forme des deuxièmes zones dopées 12a, 12b distinctes dans la couche superficielle 4. Ces deuxièmes zones dopées 12a, 12b sont réalisées entre les premières zones dopées 8a, 8b et sont accolées à ces dernières. Les deuxièmes zones dopées 12a, 12b ont des dimensions, et en particulier une épaisseur e₂ inférieure à celle e₁ des premières zones dopées 8a, 8b avec lesquelles elles se trouvent respectivement en contact.

Les deuxièmes zones dopées 12a, 12b peuvent s'étendre sur une partie seulement de l'épaisseur de la couche superficielle 4 et ont une concentration maximale en dopants située à une distance de la face supérieure (i.e. celle opposée à la face en contact avec la couche isolante 3 de BOX) de la couche superficielle 4 qui est inférieure à la distance à laquelle se trouve la concentration maximale en dopants des premières zones 8a, 8b, par rapport à la face supérieure de la couche superficielle 4. Les deuxièmes zones dopées 12a, 12b sont destinées à accueillir un ou plusieurs nano-objets. Les deuxièmes zones dopées 12a, 12b peuvent être faiblement dopées et réalisées par implantation ionique ou par une autre technique permettant de contrôler précisément la distance G entre les deuxièmes zones dopées 12a, 12b (figure 2D). La distance G entre les deuxièmes zones dopées 12a, 12b peut être comprise entre plusieurs Angströms et plusieurs micromètres, typiquement entre 10 nm et 1000 nm.

Afin de conserver intacte la surface de la couche superficielle 4 au niveau des deuxièmes zones dopées 12a, 12b, on peut effectuer un dopage de ces deuxièmes zones 12a, 12b par diffusion, en réalisant par exemple le dépôt d'une molécule contenant un espèce dopante qui diffuse dans la couche semi superficielle 4 lors d'un recuit thermique ultérieur. Un tel type de dopage par diffusion est présenté par exemple dans le document « Controlled nanoscale doping of semiconductors via molecular monolayers», de JOHNNY C. Ho, ROIE YERUSHALMI, ZACHERY A. JACOBSON ZHIYONG FAN,ROBERT L. ALLEY AND ALI JAVEY1, doi:10.1038/nmat2058.

On évite ainsi un bombardement de la surface de la couche superficielle 4. En variante, on utilise une technique d'implantation peu profonde ou d'implantation par immersion plasma à chaud afin de limiter l'endommagement de la surface de la couche superficielle 4 et d'obtenir une dose de dopants plus importante dans les premiers nanomètres en surface.

A titre d'exemple, le tableau ci-dessous répertorie des conditions d'implantation avec différents dopants de type N ou P, pour différents dimensionnements des deuxièmes zones dopées 12a, 12b, d'une couche semi superficielle 4 en silicium de 205 nm d'épaisseur d'un substrat SOI avec une couche de BOX de 400 nm et une couche de support de 725 µm. La concentration maximum de dopants est située à 8 nanomètres de profondeur dans la couche semi-conductrice superficielle avant activation des dopants.

| dopant | paramètres | Valeur min | Valeur Max | typiquement |
|---|---|---|---|---|
| | Longeur L₂ | plusieurs nm | 10 µm | 1 µm |
| Bore | Largeur W₂ | plusieurs nm | 10 µm | 300 nm |
| | Epaisseur e₂ | plusieurs nm | Plusieurs centaines de nm | 50 nm |
| | Energie | 3 kev | 50 kev | 5kev/ |
| | Dose | 1^{E}12 atm/cm² | 1^{E}16 at/cm² | 1E15 at/cm² |
| | Longeur L₂ | plusieurs nm | 10 µm | 1 µm |
| Phosphore | Largeur W₂ | plusieurs nm | 10 µm | 300 nm |
| | Epaisseur e₂ | plusieurs nm | Plusieurs centaines de nm | 50 nm |
| | Energie | 3 kev | 50 kev | 6-8kev/ |
| | Dose | 1^{E}12 atm/cm² | 1^{E}16 at/cm² | 3E14 à 3E15atm/cm²) |
| | Longeur L₂ | plusieurs nm | 10 µm | 1 µm |
| Arsenic | Largeur W₂ | plusieurs nm | 10 µm | 300 nm |
| | Epaisseur e₂ | plusieurs nm | Plusieurs centaines de nm | 50 nm |
| | Energie | 3 kev | 50 kev | As 15 kev |
| | Dose | 1^{E}12 atm/cm² | 1^{E}16 at/cm² | 5E13 atm/cm² |

Entre les deuxièmes zones 12a, 12b, on conserve une région 11 non dopée de la couche superficielle 4 ou comportant un reliquat de dopant de sorte que la concentration en dopant est de préférence inférieure à 1^{E}15 atomes/cm³.

Pour réaliser les deuxièmes zones 12a, 12b, on utilise typiquement des valeurs d'énergie inférieures à celles utilisées pour mettre en oeuvre les premières zones dopées 8a, 8b.

A l'issue de la ou des implantations, les deuxièmes zones dopées 12a, 12b ont typiquement une rugosité inférieure à celle des premières zones dopées 8a, 8b et comprise par exemple entre 1.5 et 2 Å RMS mesurée par microscope à AFM avec une surface étudiée de 1x1 µm² de silicium.

Après formation des premières zones dopées 8a, 8b et des deuxièmes zones dopées 12a, 12b on réalise au moins un recuit thermique, ce recuit thermique pouvant être composé de plusieurs étapes.

On peut également réaliser plusieurs recuits thermiques successifs, chaque recuit ayant une fonction propre. Le recuit thermique est adapté pour assurer au moins une fonction d'activation des dopants. Pour réaliser une activation des dopants, le recuit d'activation est réalisé de préférence à haute température selon une faible durée, typiquement à 1050°C pendant plusieurs secondes. Un tel type de recuit peut être réalisé à l'aide de faisceau d'électrons, faisceau laser, lampe flash ou d'un procédé de type RTP (pour « rapid thermal process ») afin de limiter la diffusion des dopants dans la couche superficielle 4 mais permettre toutefois l'activation de ces derniers. Il permet de positionner le dopant en substitutionnel, afin de rendre possible la conduction du courant.

Suivant l'application recherchée, le recuit thermique ou un autre traitement thermique peut être également prévu pour permettre de modifier le profil de dose et de répartition des dopants dans la couche superficielle 4 par phénomène de diffusion, typiquement entre 950°C et 1150°C pendant plusieurs minutes. Un tel traitement ou recuit thermique permet de réduire l'espacement G existant entre les deuxièmes zones dopées 12a et 12b, afin qu'elles soient à une distance l'une de l'autre de l'échelle du nano-objet à étudier et de sorte que celui puisse être en contact avec ces deux zones dopées 12a et 12b.

Dans le cas où les premières dopées 8a, 8b et/ou les deuxièmes zones dopées 12a, 12b ont été réalisées par implantation, le recuit thermique est également adapté de sorte à reconstruire la surface de la couche superficielle 4 et reconstituer la cristallinité du réseau.

Dans le cas où l'on cherche une zone entre les zones dopées 11 de l'ordre de plusieurs nanomètres, le recuit d'activation de dopants et de reconstruction de surface est réalisé à une température comprise par exemple entre 500°C et 1200°C, typiquement de l'ordre de 950°C, selon une durée comprise entre plusieurs secondes et plusieurs heures, typiquement de l'ordre de 8 min, plus la température est importante plus la durée de recuit choisie est courte.

A l'issue du ou des recuit(s) thermique(s) de reconstruction, les deuxièmes zones dopées 12a, 12b peuvent avoir une rugosité comprise par exemple entre 1 et 1.5 Â RMS mesuré par microscope à AFM avec une surface étudiée de 1x1 µm².

Le recuit d'activation de dopants et de reconstruction de la structure cristalline peut être réalisé sous une atmosphère adaptée de sorte à pouvoir réaliser une fonctionnalisation de la couche semi-conductrice superficielle 4. Dans ce cas, le recuit d'activation et de réparation peut également avoir pour fonction de faciliter une accroche ultérieure du nano-objet. Par « fonctionnaliser », on entend créer des liaisons chimiques et de préférence réaliser une saturation de liaisons permettant de déposer préférentiellement un nano-objet.

Lorsqu'on effectue le recuit de reconstruction et d'activation sous atmosphère contenant de l'Hydrogène (H₂) ayant une teneur en H₂ comprise par exemple entre 1% et 100%, on peut saturer en liaison Si-H la surface d'une couche superficielle 4 en silicium, ce qui peut permettre par la suite de faciliter la réalisation ou l'adhésion d'un nano-objet, par exemple par lithographie de type UHV-STM (UHV pour « ultra high vacuum » et STM pour « scanning tunneling microscopy »). Une telle surface avec des liaisons Si-H est aussi particulièrement adaptée au greffage de molécules ou par exemple de brins d'ADN.

Pour mettre en oeuvre une telle fonctionnalisation, on utilise préférentiellement un réacteur de type RP-CVD permettant d'obtenir une atmosphère de gaz hydrogène à 100%. Dans ce cas, le recuit est réalisé à une température comprise par exemple entre 800°C et 1200°C, pendant une durée comprise entre 1 min et 30 min, préférentiellement de 950°C pendant 7 min. On obtient ainsi une surface dopée et reconstruite Si(001)-(2x1):H dont la distance G entre les zones implantées peut être de l'ordre de plusieurs nanomètres à plusieurs centaines de nanomètres, ou les dopants seront activés et la surface parfaitement lissée et saturée en liaison Si-H.

En variante, à la place d'un recuit d'activation et de réparation de surface, on peut effectuer un recuit d'activation des dopants suivi d'un autre recuit de reconstruction adapté pour réparer la surface de la couche superficielle 4 et faire diffuser les dopants dans une couche 4 de silicium d'épaisseur de 205 nm Pour cette variante, on réalise par exemple un recuit d'activation par RTP, typiquement à 1050°C pendant 1 s suivi d'un recuit de diffusion des dopants à 950°C pendant 7 min et assurant aussi une fonction de lissage dans un réacteur de type RP-CVD permettant d'obtenir une atmosphère de gaz hydrogène à 100%.

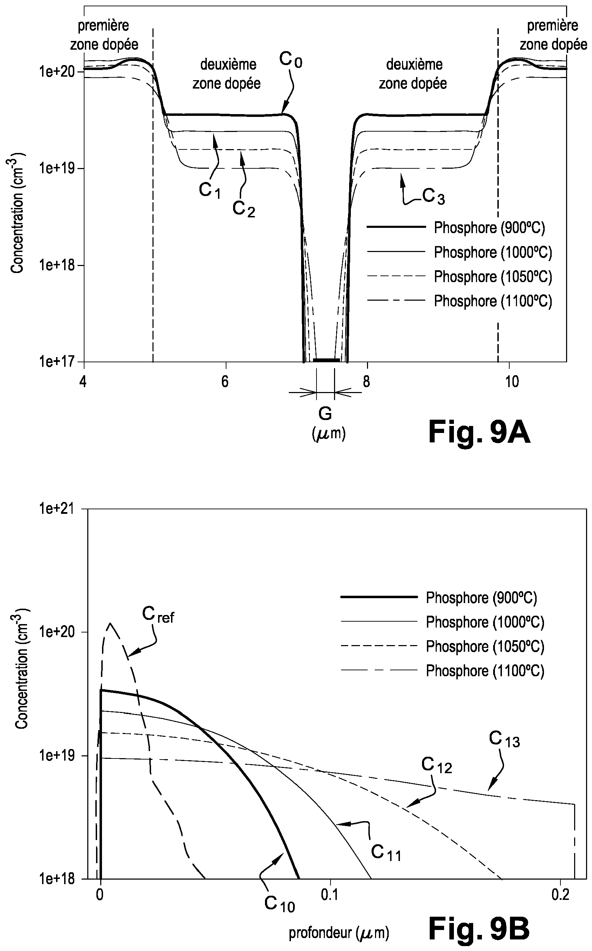

La figure 9A donne plusieurs exemples de profils C₀, C₁, C₂, C₃ de concentration en dopants de la couche superficielle après diffusion et activation de dopants, le dopage ayant été réalisé au phosphore après recuit effectué respectivement à 950°C (courbe C₀) ou à 1000°C (courbe C₁) ou 1050°C (courbe C₂) ou 1100°C (courbe C₃) pendant 7 min. Il est possible d'obtenir des premières zones et deuxièmes zones dopées avec une concentration au moins 10¹⁹ atomes/cm³. L'espacement G entre les deuxièmes zones dopées est dans cet exemple compris entre 0.2 µm et 0.6 µm. Cette distance peut être davantage réduite à 30 nm par exemple afin de connecter des nano-objets plus petits.

La figure 9B illustre quant à elle plusieurs exemples de profils C₁₀, C₁₁, C₁₂, C₁₃ en concentration de dopants dans les deuxièmes zones dopées 12a, 12b par implantation ionique au Phosphore à une énergie de l'ordre de 6 kev et une dose de 3E14 atomes/cm² pour des températures de recuit de diffusion respectivement de 950°C (courbe C₁₀) ou à 1000°C (courbe C₁₁) ou 1050°C (courbe C₁₂) ou 1100°C (courbe C₁₃) pendant 7 min sous flux d'hydrogène. Une courbe C_{ref} est quant à elle représentative d'une concentration de phosphore avant recuit.

Afin de contrôler la distance entre les deuxièmes zones dopées 12a, 12b et garder une concentration en atomes de phosphore suffisante pour pouvoir conduire le signal électrique du nano-objet, il est particulièrement intéressant de mettre en oeuvre un recuit à une température à 950°C pendant une durée de 7 min car la longueur de diffusion est alors inférieure à 0.03 µm tout en ayant une concentration en Phosphore supérieure à 10¹⁹ at/cm³. Un recuit à une température inférieure à 1100°C est dans cet exemple privilégié.

On forme ensuite un nano-objet 50 sur la face supérieure de la couche superficielle 4 c'est-à-dire celle sur laquelle les premières zones dopées 8a, 8b, et 12a, 12b ont été réalisées (figure 8E). Le nano-objet 50 est disposé de sorte à être en contact avec les deuxièmes zones dopées 12a, 12b et éventuellement avec une portion des premières zones dopées 8a, 8b. Le nano-objet 50 peut être par exemple sous forme de nano-particules organiques ou inorganiques, de molécule(s), en particulier de molécule(s) biologique(s), telle qu'une protéine, de l'ADN, un virus, ou un anti-corps. Selon un autre exemple, le nano-objet 50 peut être un nano-fil.

Par « formation » du nano-objet 50, on inclus notamment une modification de surface (fonctionnalisation) et/ou un greffage, ou un collage, ou un dépôt suivi éventuellement d'une structuration par exemple par lithographie.

Le placement précis du nano-objet 50 sur les deuxièmes zones dopées 12a, 12b peut être effectué de manière automatisée par un équipement configuré pour détecter les marques 5 de localisation.

Une couche d'encapsulation peut être ensuite formée de sorte à protéger le nano-objet 50. Pour un nano-objet 50 de nature organique, la couche d'encapsulation peut être par exemple prévue à base de résine. Pour un nano-objet 50 inorganique, on peut par exemple prévoir une couche d'encapsulation en silicium ou en oxyde de silicium.

De même, on peut avantageusement prévoir une couche de protection 6 sur la couche semi-conductrice superficielle 4 préalablement aux étapes de réalisation des première zones dopées 8a, 8b et des deuxièmes zones dopées 12a, 12b. Cette couche de protection 6 peut être par exemple en oxyde de silicium et être réalisée par oxydation thermique de la couche superficielle 4. L'épaisseur de la couche de protection 6 peut être par exemple de l'ordre de 10 nm.

On effectue ensuite des étapes d'implantation de la couche superficielle 4 pour former les première et deuxièmes zones dopées 8a, 8b, 12a, 12b, lors desquelles la couche de protection 6 permet de limiter l'endommagement en surface de la couche superficielle (figure 10).

Un dispositif suivant l'invention tel que décrit précédemment et muni d'au moins un nano-objet disposé sur et en contact de zones dopées de faible épaisseur peut être utilisé pour mettre en oeuvre une structure de transistor OFET (pour « Organic Field Effect Transistor ») avec un nano-objet de nature organique et formant une structure de canal du transistor.

Un dispositif à nano-objet tel que décrit précédemment peut être également utilisé pour réaliser un commutateur ou un amplificateur, ou un capteur biologique (bio-capteur). Dans le cas d'un commutateur, le ou les nano-objets sont destinés à jouer le rôle d'interrupteur. Dans ce cas, le nano objet est typiquement sous forme d'une molécule posée sur les zones 12a et 12b. Sous l'effet d'un courant électrique, une partie de la molécule s'aligne sur les zones 12a et 12b conduisant alors le courant (position « ON » de l'interrupteur). Quand le courant est arrêté, une partie de la molécule se détache des zones 12 a ou b, et le courant ne passe plus (position « OFF » de l'interrupteur).

Dans le cas d'une application capteur biologique, un nano-objet est déposée posée entre les zones 12a et 12b, typiquement une molécule sensible à un élément, par exemple à un gaz tel que du CO₂. Lorsque cet élément est au contact de la molécule, celui s'accroche à la molécule. Cela va alors engendrer une modification du signal électrique qui peut être alors détecté par la source SEE.

## Revendications

1. Dispositif pour connecter au moins un nano-objet à un système électrique externe, comprenant un support (1, 100) doté d'une couche semi-conductrice (4) dans laquelle des premières zones dopées (8a, 8b) espacées entre elles sont agencées, un système électrique externe (SEE) étant apte à être connecté aux premières zones dopées, **caractérisé en ce que** chaque première zone dopée (8a, 8b) étant en contact avec une deuxième zone dopée (12a, 12b) sur laquelle une portion du nano-objet est apte à être disposée, les deuxièmes zones dopées (12a, 12b) étant espacées entre elles d'une distance G et ayant une épaisseur (e₂) inférieure à l'épaisseur (e₁) des première zones dopées.

2. Dispositif selon la revendication 1, dans lequel les premières zones dopées (8a, 8b) ont une première surface en vue de dessus et dans lequel les deuxièmes zones dopées (12a, 12b) ont une deuxième surface en vue de dessus inférieure à la première surface.

3. Dispositif selon l'une des revendications 1 ou 2, dans lequel l'épaisseur (e₁) des premières zones dopées (8a, 8b) est égale à l'épaisseur (e) de ladite couche semi-conductrice (4).

4. Dispositif selon l'une des revendications 1 à 3, dans lequel les premières zones dopées (8a, 8b) sont entourées d'une région isolante (41).

5. Dispositif selon l'une des revendications 1 à 4, dans lequel le support est un substrat (1) comprenant un empilement composé d'une couche de support (2), d'une couche isolante (3) et de ladite couche semi-conductrice (4),
le dispositif étant doté d'éléments conducteurs (19a, 19b) en contact avec les premières zones dopées (8a, 8b) et traversant la couche de support (2) et la couche isolante (3).

6. Dispositif selon l'une des revendications 1 à 5, comprenant un autre ensemble de premières zones dopées et de deuxièmes zones dopées espacées entre elles, chaque deuxième zone dopée de cet autre ensemble étant en contact avec une première zone dopée distincte de cet autre ensemble, et apte à recevoir une portion d'un autre nano-objet.

7. Dispositif selon l'une des revendications 1 à 6, dans lequel un nano-objet comporte une première portion disposée sur une desdites deuxièmes zones dopées et une deuxième portion sur une autre desdites deuxièmes zones dopées, ladite autre deuxième zone dopée comportant une autre portion d'un autre nano-objet.

8. Dispositif selon l'une des revendications 1 à 7, dans lequel le nano-objet (50) comporte une première portion disposée sur une desdites deuxième zones dopées ayant un dopage de type N et une deuxième portion sur une autre desdites deuxièmes zones dopées, ladite autre deuxième zone dopée ayant un dopage de type P.

9. Procédé de réalisation d'un dispositif pour connecter au moins un nano-objet à un système électrique externe, le procédé comprenant des étapes consistant à :
a) former dans une couche semi-conductrice (4) d'un support (1) des premières zones dopées (8a, 8b) sur lesquelles le système électrique externe est apte à être connecté, les premières zones dopées ayant une première épaisseur (e₁) puis,
b) former des deuxièmes zones dopées (12a, 12b) entre les premières zones dopées de sorte que chaque deuxième zone dopée soit en contact avec une première zone dopée, les deuxièmes zones dopées étant séparées entre elles d'une distance G et présentant une deuxième épaisseur (e₂) inférieure à ladite première épaisseur,
c) disposer un nano-objet sur les deuxièmes zones dopées.

10. Procédé selon la revendication 9, dans lequel les premières zones dopées (8a, 8b) et deuxièmes zones dopées (12a, 12b) sont formées par implantation(s) ionique(s), le procédé comprenant après formation des premières et deuxièmes zones dopées et préalablement à l'étape c) au moins un recuit thermique, de sorte à activer les dopants des première et deuxième zones dopées et définir la distance G.

11. Procédé selon la revendication 10, dans lequel ledit au moins un recuit thermique est effectué sous une atmosphère prévue de sorte à fonctionnaliser les deuxièmes zones dopées.

12. Procédé selon la revendication 11, dans lequel le ou les recuits sont effectués sous atmosphère d'hydrogène.

13. Procédé selon l'une des revendications 9 à 12, dans lequel le support est un substrat (1) de type semi-conducteur sur isolant comprenant sur une couche support, une couche isolante (3) sur laquelle repose ladite couche semi-conductrice (4), le procédé comprenant en outre après l'étape c), des étapes de :
- assemblage de la couche semi-conductrice (4) à un autre support (100), puis
- retrait de la couche de support (2) et de la couche isolante (3) dudit substrat.

14. Procédé selon la revendication 13, dans les premières zones dopées (8a, 8b) sont formées partiellement à l'aide d'au moins une implantation à l'aide d'un faisceau d'ions pénétrant par une première face de la couche semi-conductrice (4), cette première face étant mise en contact avec le support lors dudit assemblage et étant opposée à une deuxième face en contact avec le substrat, puis, après retrait du substrat:
au moins une autre implantation à l'aide d'un faisceau d'ions pénétrant par la deuxième face de la couche semi-conductrice, de sorte à étendre les premières zones dopées.

15. Procédé selon l'une des revendications 9 à 14, dans lequel le support comprend une couche de support (2) sur laquelle repose une couche isolante (3) sur laquelle la couche semi-conductrice (4) est disposée, le procédé comprenant en outre une étape de formation d'éléments conducteurs en contact avec les premières zones dopées et traversant la couche de support et la couche isolante.

16. Procédé selon l'une des revendications 9 à 15, dans lequel les premières zones dopées (8a, 8b) ont une épaisseur (e₁) égale à l'épaisseur (e) de la couche semi-conductrice (4).

## Patentansprüche

1. Vorrichtung zum Anschließen wenigstens eines Nanoobjekts an ein externes elektrisches System, umfassend einen Träger (1, 100), der mit einer Halbleiterschicht (4) versehen ist, in der erste dotierte Zonen (8a, 8b) angeordnet sind, die voneinander beabstandet sind, wobei ein externes elektrisches System (SEE) dazu ausgelegt ist, an die ersten dotierten Zonen angeschlossen zu sein, **dadurch gekennzeichnet, dass** jede erste dotierte Zone (8a, 8b) in Kontakt mit einer zweiten dotierten Zone (12a, 12b) ist, auf der ein Bereich des Nanoobjekts angeordnet werden soll, wobei die zweiten dotierten Zonen (12a, 12b) voneinander in einem Abstand G beabstandet sind und eine Dicke (e₂) haben, die kleiner ist als die Dicke (e₁) der ersten dotierten Zonen.

2. Vorrichtung nach Anspruch 1, wobei die ersten dotierten Zonen (8a, 8b) in einer Draufsicht eine erste Oberfläche haben, und wobei die zweiten dotierten Zonen (12a, 12b) in einer Draufsicht eine zweite Oberfläche haben, die kleiner als die erste Oberfläche ist.

3. Vorrichtung nach einem der Ansprüche 1 oder 2, wobei die Dicke (e₁) der ersten dotierten Zonen (8a, 8b) gleich der Dicke (e) der Halbleiterschicht (4) ist.

4. Vorrichtung nach einem der Ansprüche 1 bis 3, wobei die ersten dotierten Zonen (8a, 8b) von einer isolierenden Region (41) umgeben sind.

5. Vorrichtung nach einem der Ansprüche 1 bis 4, wobei der Träger ein Substrat (1) ist, umfassend einen Stapel, der gebildet ist aus einer Trägerschicht (2), einer isolierenden Schicht (3) und der Halbleiterschicht (4),
wobei die Vorrichtung mit Leiterelementen (19a, 19b) versehen ist, die in Kontakt mit den ersten dotierten Zonen (8a, 8b) sind und die Trägerschicht (2) und die isolierende Schicht (3) durchsetzen.

6. Vorrichtung nach einem der Ansprüche 1 bis 5, umfassend eine weitere Gesamtheit von ersten dotierten Zonen und von zweiten dotierten Zonen, die voneinander beabstandet sind, wobei jede zweite dotierte Zone dieser weiteren Gesamtheit in Kontakt mit einer verschiedenen ersten dotierten Zone dieser weiteren Gesamtheit ist, und dazu ausgelegt ist, einen Bereich eines weiteren Nanoobjekts aufzunehmen.

7. Vorrichtung nach einem der Ansprüche 1 bis 6, wobei ein Nanoobjekt einen ersten Bereich umfasst, der auf einer der zweiten dotierten Zonen angeordnet ist, und einen zweiten Bereich auf einer anderen der zweiten dotierten Zonen, wobei die andere zweite dotierte Zone einen anderen Bereich eines anderen Nanoobjekts umfasst.

8. Vorrichtung nach einem der Ansprüche 1 bis 7, wobei das Nanoobjekt (50) einen ersten Bereich umfasst, der auf einer der zweiten dotierten Zonen angeordnet ist, die eine Dotierung vom Typ N hat, und einen zweiten Bereich auf einer anderen der zweiten dotierten Zonen, wobei die andere zweite dotierte Zone eine Dotierung von Typ P hat.

9. Verfahren zur Herstellung einer Vorrichtung zum Anschließen wenigstens eines Nanoobjekts an ein externes elektrisches System, wobei das Verfahren die folgenden Schritte umfasst:
a) Bilden, in einer Halbleiterschicht (4) eines Trägers (1), von ersten dotierten Zonen (8a, 8b), auf denen das externe elektrische System angeschlossen werden soll, wobei die ersten dotierten Zonen eine erste Dicke (e₁) haben, dann
b) Bilden von zweiten dotierten Zonen (12a, 12b) zwischen den ersten dotierten Zonen derart, dass jede zweite dotierte Zone in Kontakt mit einer ersten dotierten Zone ist, wobei die zweiten dotierten Zonen voneinander in einem Abstand G getrennt sind und eine zweite Dicke (e₂) aufweisen, die kleiner als die erste Dicke ist,
c) Anordnen eines Nanoobjekts auf den zweiten dotierten Zonen.

10. Verfahren nach Anspruch 9, wobei die ersten dotierten Zonen (8a, 8b) und die zweiten dotierten Zonen (12a, 12b) durch Ionenimplantation(en) gebildet werden, wobei das Verfahren nach der Bildung der ersten und zweiten dotierten Zonen und vor dem Schritt c) wenigstens ein thermisches Tempern umfasst, um die Dotierungsstoffe der ersten und zweiten dotierten Zonen zu aktivieren und den Abstand G zu definieren.

11. Verfahren nach Anspruch 10, wobei das wenigstens eine thermische Tempern unter einer Atmosphäre durchgeführt wird, die derart vorgesehen ist, dass die zweiten dotierten Zonen funktionalisiert werden.

12. Verfahren nach Anspruch 11, wobei das Tempern/die Temperungen unter Wasserstoffatmosphäre durchgeführt werden.

13. Verfahren nach einem der Ansprüche 9 bis 12, wobei der Träger ein Substrat (1) vom Typ Halbleiter-auf-Isolator ist, umfassend auf einer Trägerschicht eine isolierende Schicht (3), auf der die Halbleiterschicht (4) ruht, wobei das Verfahren ferner nach dem Schritt c) die folgenden Schritte umfasst:
- Anbringen der Halbleiterschicht (4) an einem anderen Träger (100), dann
- Entfernen der Trägerschicht (2) und der isolierenden Schicht (3) des Substrats.

14. Verfahren nach Anspruch 13, wobei die ersten dotierten Zonen (8a, 8b) teilweise mittels wenigstens einer Implantation mittels eines lonenstrahls gebildet werden, der durch eine erste Fläche der Halbleiterschicht (4) hindurch dringt, wobei dieser erste Fläche während des Anbringens in Kontakt mit dem Träger gebracht wird und einer zweiten Fläche in Kontakt mit dem Substrat entgegengesetzt ist, und dann nach dem Entfernen des Substrats:
wenigstens eine weitere Implantation mittels eines lonenstrahls, der durch die zweite Fläche der Halbleiterschicht hindurch dringt, derart, dass die ersten dotierten Zonen erweitert werden.

15. Verfahren nach einem der Ansprüche 9 bis 14, wobei der Träger eine Trägerschicht (2) umfasst, auf der eine isolierende Schicht (3) ruht, auf der die Halbleiterschicht (4) angeordnet ist, wobei das Verfahren ferner einen Schritt des Bildens von leitenden Elementen in Kontakt mit den ersten dotierten Zonen umfasst, die die Trägerschicht und die isolierende Schicht durchsetzen.

16. Verfahren nach einem der Ansprüche 9 bis 15, wobei die ersten dotierten Zonen (8a, 8b) eine Dicke (e₁) gleich der Dicke (e) der Halbleiterschicht (4) haben.

## Claims

1. A device to connect at least one nano-object to an external electrical system, said device comprising a support (1, 100) provided with a semiconducting layer (4) in which the first doped zones (8a, 8b) are formed at a spacing from each other, an external electrical system (SEE) being connectable to the first doped zones, **characterized in that** each first doped zone (8a, 8b) being in contact with a second doped zone (12a, 12b) on which a portion of the nano-object is located, the second doped zones (12a, 12b) being separated from each other by a distance G and with a thickness less than the thickness (e₂) of the first doped zones.

2. The device according to claim 1, wherein the first doped zones (8a, 8b) have a first surface and the second doped zones (12a, 12b) have a second surface smaller than the first surface.

3. The device according to any of the claims 1 or 2, wherein the thickness (e₁) of the first doped zones (8a, bb) is equal to the thickness (e) of said semiconducting layer (4).

4. The device according to any of the claims 1 to 3, wherein the first doped zones (8a, 8b) are surrounded by an insulating region (41).

5. The device according to any of the claims 1 to 4, wherein the support is a substrate (1) comprising a stack composed of a support layer (2), an insulating (3) layer and said semiconducting layer (4), the device being provided with conducting elements (19a, 19b) in contact with the first doped zones and passing through the support layer (2) and the insulating layer (3).

6. The device according to any of the claims 1 to 5, comprising another set of first doped zones and second doped zones at a spacing from each other, each doped zone of this other set being in contact with a first doped zone distinct from said other set, and suitable for holding a portion of another a nano-object.

7. The device according to any of the claims 1 to 6, wherein a nano-object comprises a first portion located on one of said second doped zones and a second portion located on another of said second doped zones, said other doped zone comprising another portion of another nano-object.

8. The device according to any of the claims 1 to 7, wherein the nano-object (50) comprises a first portion located on one of said second doped zones with N type doping and a second portion located on another of said second doped zones, said other doped zone having a P type doping.

9. A method of making a device to connect at least one nano-object to an external electrical system, the method including:
- forming first doped zones (8a, 8b) on which the external electrical system can be connected in a semiconducting layer (4) of a support (1), the first doped zones having a thickness (e₁), then
- forming second doped zones (12a, 12b) between the first doped zones such that each second doped zone is in contact with a first doped zone, the second doped zones being separated from each other by a distance G and having a second thickness (e₂) less than said first thickness,
- placing a nano-object on the second doped zones.

10. The method according to claim 9, wherein the first doped zones (8a, 8b) and the second doped zones (12a, 12b) are formed by ion implantation, the method including at least one thermal annealing after formation of the first and second doped zones and before placing said nano-object on the second doped zones, so as to activate dopants in the first and second doped zones and to define the distance G.

11. The method according to claim 10, wherein said at least one thermal annealing is done under an atmosphere that will functionalise the second doped zones.

12. The method according to claim 11, wherein the annealing(s) is (are) done under a hydrogen atmosphere.

13. The method according to any of the claims 9 to 12, wherein the support (1) is a substrate of the semiconductor on insulator type comprising an insulating layer (3) on a support layer, on which said semiconducting layer (4) is supported, the method further including the following steps after the step of placing said nano-object on the second doped zones:
- assembling the semiconducting layer (4) on another support (100), then,
- remove the support layer (2) and the insulating layer (3) from said support.

14. Method according to claim 13, wherein the first doped zones are formed partially using at least one implantation using an ion beam penetrating through a first face of the semiconducting layer (4), said first face being put into contact with the support during said assembly and being opposite a second face in contact with the substrate, then after removal of the substrate:
at least one other implantation using an ion beam penetrating through the second face of the semiconducting layer, so as to extend the first doped zones.

15. The method according to any of the claims 9 to 14, wherein the support comprises a support layer (2) on which an insulating layer (3) rests, the semiconducting layer (4) being located on the insulating layer, the method further including a step in which conducting elements are formed in contact with the first doped zones and passing through the support layer and the insulating layer.

16. The method according to any of the claims 9 to 15, wherein the thickness of the first doped zones (8a, 8b) is equal to the thickness (e₁) of the semiconducting layer (e).
